# EUROPÄISCHE PATENTSCHRIFT

(11) **EP 2 724 374 B1**
(45) Veröffentlichungstag und Bekanntmachung des Hinweises auf die Patenterteilung: **19.08.2020**
(21) Anmeldenummer: 12731380.7
(22) Anmeldetag: 22.06.2012
(51) Int. Cl.: H01L 29/732, H01L 29/08, H01L 29/06, H01L 29/40, H01L 29/735

(54) **VERTIKALER BIPOLARTRANSISTOR MIT LATERALEM KOLLEKTOR-DRIFTGEBIET**
VERTICAL BIPOLAR TRANSISTOR HAVING A LATERAL COLLECTOR DRIFT REGION
TRANSISTOR BIPOLAIRE VERTICAL COMPRENANT UNE RÉGION LATÉRALE DE DÉRIVE DE COLLECTEUR

(30) Priorität: 24.06.2011 DE 102011078072; 17.10.2011 DE 102011084642
(43) Veröffentlichungstag der Anmeldung: 30.04.2014
(73) Patentinhaber: IHP GmbH-Innovations for High Performance Microelectronics / Leibniz-Institut für innovative Mikroelektronik, 15236 Frankfurt / Oder (DE)
(72) Erfinder: SORGE, Roland, 15236 Frankfurt (Oder) (DE)
(74) Vertreter: Eisenführ Speiser
(86) Internationale Anmeldenummer: PCT/EP2012/062155
(87) Internationale Veröffentlichungsnummer: WO 2012/175716

(56) Entgegenhaltungen:
- WO-A1-2008/026175
- WO-A1-2009/107086
- US-A- 5 091 336
- US-A1- 2004 046 186
- US-A1- 2008 017 895
- US-B1- 7 569 872

## Beschreibung

Die Erfindung bezieht sich auf vertikale npn- und pnp-Bipolartransistoren und HeteroBipolartransistoren.

An das Basisgebiet eines vertikalen npn- oder pnp- Bipolartransistors schließt sich üblicherweise eine Kollektorschicht an. Unterhalb der Kollektorschicht befindet sich eine deutlich höher dotierte Subkollektorzone. Über der schwächer dotierten Kollektorschicht fällt im aktiv normalen Betriebszustand des Transistors der wesentliche Teil der Kollektor-Emitterspannung ab.

In modernen CMOS Technologien finden integrierte Hochfrequenz(RF)-Bipolartransistoren eine breite Anwendung in Form von analogen Schaltungen wie Mixern, Oszillatoren, Modulatoren und Leitungsverstärkern sowie schnellen Logikschaltungen. Insbesondere für RF-Leistungsverstärker ist zur Erzielung von hohen Ausgangsleistungen eine große Kollektor-Emitter-Spannung notwendig.

Hochvolt-Bipolartransistoren mit sehr guten Hochfrequenzparametern finden Anwendung in Schaltungen, die ein hohes Verstärkungs-Bandbreite-Produkt und extrem kurze Signalanstiegszeiten erfordern. Deshalb sind derartige Hochvolt-Bipolartransistoren besonders gut für schnelle Hochvolt-Operationsverstärker, schnelle Regelkreise sowie Hochfrequenz-Mixed-Signal-Anwendungen geeignet. Insbesondere ermöglichen integrierte Hochvolt-Bipolartransistoren mit sehr guten Hochfrequenzparametern die kostengünstige Herstellung von Leistungsverstärkern für die drahtlose Kommunikation bis hinein in den Frequenzbereich von 8-12 GHz, wie er für X-Band Radar-Applikationen typisch ist.

Der prozesstechnische Stand der Technik zur Erzielung von großen verfügbaren Kollektor-Emitter Durchbruchspennungen ist in der Veröffentlichung F. W. Ragay, A. Aarnink and H. Wallinga, "Complementary Vertical Bipolar Transistor Process Using High-Energy Ion Implantation", Electronics Letters, vol. 27 no. 23, pp.2141-2143 (1991) beschrieben.

Auch WO 2008/026175 A1 zeigt ein Verfahren zur Herstellung eines vertikalen Bipolartransistors. Bei dem Bipolartransistor, mit einem lateralen Kollektorgebiet zwischen dem inneren Kollektor und dem Kollektoranschlussgebiet, wird eine Schicht in einem Graben angrenzend an eine Kollektorregion als RESURF-Schicht eingesetzt.

US 7,569,872 B1 beschreibt einen III-V Heteroübergang-Bipolartransistor und seine Herstellungsmethode. Der Bipolartransistor hat ein inneres Kollektorgebiet, ein Kollektoranschlussgebiet mit höherer Dotierung über einem nicht dotierten InP Substrat, sowie ein Kollektorgebiet zwischen dem inneren Kollektorgebiet und dem Kollektoranschlussgebiet, das die gleiche Dotierstoffkonzentration wie das innere Kollektorgebiet hat.

In US 5,091,336 A ist ein mittels Implantation hergestellter Transistor mit einem pn-Übergang beschrieben, wobei das n- dotierte Substrat an seiner Oberfläche eine laterale Verbindung zwischen innerem Kollektorgebiet und Kollektoranschlussgebiet herstellt.

US 2008/0017895 A1 beschreibt verschiedene Dotierungsprofile eines npn-Transistors in einer Feldplatte.

Ein der Erfindung zugrunde liegendes technisches Problem ist es, einen vertikalen Bipolartransistor mit erhöhter Spannungsfestigkeit und ein Verfahren zu seiner Herstellung vorzuschlagen.

Die Lösung gelingt erfindungsgemäß durch einen vertikalen Bipolartransistor mit einer besonderen Konstruktion eines Kollektorgebietes, das im Vergleich mit bekannten Kollektorgebieten zusätzlich ein laterales Driftgebiet aufweist.

Diese Lösung verwirklicht ein vertikaler npn- Bipolartransistor mit einem lateralen Driftgebiert, LDVB-Transistor, gemäß Anspruch 1 mit einer vertikalen Schichtfolge von Emitter, Basis und Kollektor, bei dem der Kollektor ein dotiertes inneres Kollektorgebiet eines ersten Leitfähigkeitstyps und ein im Vergleich mit dem inneren Kollektorgebiet höher dotiertes Kollektoranschlussgebiet des ersten Leitfähigkeitstyps aufweist, und bei dem an das innere Kollektorgebiet in einer lateralen Richtung, die quer zu einer vertikalen Stapelrichtung der Schichtfolge weist, ein im Vergleich mit dem inneren Kollektorgebiet schwächer dotiertes Kollektor-Driftgebiet des ersten Leitfähigkeitstyps anschließt, über welches das innere Kollektorgebiet mit dem Kollektoranschlussgebiet verbunden ist, und bei dem die Dotierstoffkonzentration des Kollektor-Driftgebiets derart bemessen ist, dass eine maximale flächenbezogene Dichte von freien Ladungsträgern von 2.5x10¹² cm⁻² nicht überschritten wird.

Dieses Kollektor-Driftgebiet stellt insbesondere die einzige elektrische Verbindung zwischen dem inneren Kollektorgebiet und dem Kollektoranschlussgebiet dar. Ein Substrat weist dem entsprechend unterhalb des Kollektor-Driftgebietes sowohl über die gesamte Erstreckung des Kollektor-Driftgebietes in der lateralen Richtung als auch über die gesamte Erstreckung des Substrats in seiner zur Stapelrichtung entgegengesetzten Tiefenrichtung durchweg kein zur Reduzierung des Kollektorwiderstandes geeignetes Hochdotierungsgebiet vom ersten Leitfähigkeitstyp auf

Ein derart ausgebildetes und angeordnetes Hochdotierungsgebiet ist im Stand der Technik zur Reduzierung des Kollektorwiderstandes bei vertikalen Bipolartransistoren üblich. Bei dem Bipolartransistor der vorliegenden Erfindung ist es jedoch ausdrücklich nicht vorhanden.

Im Folgenden wird der erfindungsgemäße vertikale Bipolartransistor mit einem lateralen Driftgebiet auch als LDVB-Transistor oder als LDVBT bezeichnet. Ein LDVB-Transistor zeichnet sich gegenüber herkömmlichen vertikalen Bipolartransistoren wie gerade erläutert dadurch aus, dass das ansonsten vertikal ausgebildete hoch dotierte Sub-Kollektorgebiet nicht vorhanden ist, sondern stattdessen vielmehr ein Gebiet mit niedriger Dotierung vorhanden ist, welches lateral eine Erweiterung in Form eines niedrig dotierten Kollektor-Driftgebietes ohne eine solche darunter liegende hoch dotierte Schicht vom gleichen Leitfähigkeitstyp erfährt. In dieser niedrig dotierten lateralen Driftzone wird die Bewegung der Ladungsträger nur durch das elektrische Feld zwischen einem äußeren Kollektoranschluss und dem inneren vertikalen Kollektorgebiet gesteuert. Die Länge der Driftzone erstreckt sich vom inneren vertikalen Kollektorgebiet bis zu dem in einem beliebig weiten lateralen Abstand liegenden äußeren Kollektoranschlussgebiet, welches durch den Kollektorkontakt angeschlossen ist.

In der Drift-Zone des LDVB-Transistors befindet sich zwischen dem inneren vertikalen Kollektorgebiet und dem äußeren hoch dotierten Kollektoranschlussgebiet ein schwach dotiertes laterales Kollektorgebiet, kurz LDC-Gebiet (low doped collector-Gebiet). Das entsprechend schwach dotierte LDC-Gebiet ist vom selben Leitfähigkeitstyp wie das innere vertikale Kollektorgebiet. Die Dotierung im LDC-Gebiet wird vorzugsweise derart eingestellt, dass sich dort bereits bei sehr kleinen Kollektor-Emitter-Spannungen eine vollständige Verarmung an freien Ladungsträgern ergibt. Letzteres wird erfindungsgemäß erreicht, indem die Dotierstoffkonzentration des Kollektor-Driftgebiets derart bemessen ist, dass eine maximale flächenbezogene Dichte von freien Ladungsträgern von 2.5x10¹² cm⁻² nicht überschritten wird.

Die Struktur des LDVB-Transistors ermöglicht die Herstellung von CMOS-kompatiblen RF-Bipolartransistoren mit einer mit einer nur durch die Länge des LDC Gebietes bestimmten, und daher insbesondere auch hoch wählbaren Kollektor-Emitter Durchbruchspannung. Die Länge des Driftgebiets kann an die Erfordernisse der Kollektor-Emitter-Durchbruchspannung in einem vorgegebenen Anwendungsfall angepasst werden.

Mit dem erfindungsgemäßen Bipolartransistor gelingt es, insbesondere für RF-Leistungsanwendungen eine Vergrößerung des verfügbaren Ausgangsspannungsbereiches von integrierten RF-Bipolartransistoren zu ermöglichen.

Desweiteren wird ein erfindungsgemäßes Verfahren zur Herstellung eines solchen Transistors, wie in Anspruch 11 beansprucht, beschrieben. Das Verfahren zur Herstellung eines vertikalen Bipolartransistors nach einem der vorstehenden Ansprüche, umfasst:
- Herstellen des Bipolar-Transistors mittels bekannter Halbleiterfertigungstechnologien, insbesondere im Rahmen eines Bi-CMOS-Prozesses, umfassend Ausbilden einer vertikalen Schichtfolge von Emitter, Basis und Kollektor,
- wobei der Kollektor mit einem dotierten inneren Kollektorgebiet eines ersten Leitfähigkeitstyps und einem im Vergleich mit dem inneren Kollektorgebiet höher dotierten Kollektoranschlussgebiet des ersten Leitfähigkeitstyps hergestellt wird, und
- wobei an das innere Kollektorgebiet in einer lateralen Richtung, die quer zu einer vertikalen Stapelrichtung der Schichtfolge weist, angrenzend ein dotiertes Kollektor-Driftgebiet des ersten Leitfähigkeitstyps hergestellt wird, über welches das innere Kollektorgebiet mit dem Kollektoranschlussgebiet verbunden ist, und bei dem die Dotierstoffkonzentration des Kollektor-Driftgebiets derart bemessen ist, dass eine maximale flächenbezogene Dichte von freien Ladungsträgern von 2.5x10¹² cm⁻² nicht überschritten wird.

Ein wesentlicher Vorteil bei der Herstellung von LDVBTs besteht in der relativ einfachen Integrierbarkeit in vorhandene BiCMOS Technologien, so dass sich durch die gewählte Länge und Dotierung des lateralen Driftraumes jede gewünschte Durchbruchspannung BV_{CEO} einstellen lässt und keine zusätzlichen Prozessschritte wie Epitaxie oder Hochenergieimplantation, welche ansonsten zur Herstellung eines tief in vertikaler Richtung ausgedehnten niedrig dotierten Kollektorgebietes und der zugehörigen Konstruktionen zum Anschluss dieser Gebiete an der Oberfläche benötigt werden.

Nachfolgend werden Ausführungsbeispiele des erfindungsgemäßen Transistors und des erfindungsgemäßen Herstellungsverfahrens beschrieben.

Das laterale Kollektor-Driftgebiet wird bevorzugt mittels Ionenimplantation in einem von einer Dotierung des inneren Kollektorgebiets getrennten Maskenschritt dotiert. Das Kollektor-Driftgebiet wird vorzugsweise im Vergleich mit dem inneren Kollektorgebiet schwächer dotiert. Seine Dotierstoffkonzentration wird so eingestellt, dass eine Flächendichte der lateral verarmten Ladungsträger stets kleiner als 2.5x10¹² cm⁻² ist.

Das innere Kollektorgebiet erstreckt sich in einem Ausführungsbeispiel von einer Grenzfläche mit einer Basisschicht ausgehend in der vertikalen Richtung in ein Substrat hinein, und das Kollektor-Driftgebiet ist im Substrat vergraben angeordnet.

Vorzugsweise erstreckt sich über dem Kollektor-Driftgebiet in lateraler Richtung ein RESURF-Gebiet mit einem dem ersten Leitfähigkeitstyp entgegengesetzten zweiten Leitfähigkeitstyp. Das RESURF-Gebiet ist insbesondere -in der vertikalen Richtung betrachtet- über dem Kollektor-Driftgebiet und -in der lateralen Richtung betrachtetzwischen dem inneren Kollektorgebiet und dem Kollektor-Anschlussgebiet ein Isolationsgebiet angeordnet. Dieses parallel zur Oberfläche verlaufende RESURF-Gebiet bewirkt eine zusätzliche, senkrecht zur Stromflussrichtung verlaufende Verarmung an freien Ladungsträgen im Driftraum. Dadurch kann die Dotierung im LDC-Gebiet erhöht werden, ohne dass sich die Spannungsfestigkeit des Transistors dadurch vermindert. Die sich daraus ergebende Verkleinerung des Kollektorwiderstands verbessert die Hochfrequenzeigenschaften des Bauelements.

Der LDVBT ist vorzugsweise lateral von einem in Shallow-Trench- oder LOCOS-Technik hergestellten Bauelemente-Isolationsgebiet umgeben. Das Bauelemente-Isolationsgebiet und das Isolationsgebiet können eine unterschiedliche Tiefenausdehnung aufweisen. Das Isolationsgebiet kann als Gateoxid, CVD-Oxid, ein durch Shallow-Trench- oder LOCOS-Techniken hergestelltes Oxid oder als Kombination der genannte Oxide in lateraler Richtung ausgeführt sein.

Das Bauelemente-Isolationsgebiet und das Isolationsgebiet weisen in einer Variante jedoch in vertikaler Richtung die gleiche Tiefenerstreckung auf, was insbesondere durch ihre gleichzeitige Herstellung in derselben Technologie zuverlässig verwirklicht werden kann.

Das mit Shallow-Trench- oder in LOCOS-Technik hergestellte Isolationsgebiet erstreckt sich in einem Ausführungsbeispiel in der lateralen Richtung über die gesamte laterale Ausdehnung des Kollektor-Driftgebiets bis zum Kollektor-Anschlussgebiet. Bei dieser Ausführungsform ist vorteilhafterweise auf dem dicken Isolationsgebiet ein mit einem inneren Basisgebiet verbundenes, erweitertes Basisanschlussgebiet des zweiten Leitfähigkeitstyps angeordnet, welches in lateraler Richtung einen Teil des Isolationsgebiets bedeckt. Damit wird die weiter unten näher beschriebene Wirkung einer Feldplatte erzielt. Das Basisanschlussgebiet kann sich beispielsweise etwa über die Hälfte der lateralen Ausdehnung des Isolationsgebiets erstrecken.

Eine Dotierstoffkonzentration des Kollektor-Driftgebiets ist bevorzugt derart bemessen, dass das Kollektor-Driftgebiet ab einem vorbestimmten, insbesondere geringen Schwellwert einer Kollektor-Emitter-Spannung vollständig an freien Ladungsträgern verarmt ist. Die Dotierstoffkonzentration des Kollektor-Driftgebiets ist so bemessen, dass eine maximale flächenbezogene Dichte von freien Ladungsträgern von 2.5x10¹² cm⁻² nicht überschritten wird. Somit kann das Einsetzen einer lawinenartigen Trägervervielfachung nach Erreichen der Durchbruchfeldstärke im Kollektor-Driftgebiet vermieden werden.

Nachfolgend werden weitere Ausführungsbeispiele anhand der Figuren beschrieben. Es zeigen:
Fig. 1 eine schematische Querschnittsansicht eines Ausführungsbeispiels eines npn-LDVB-Transistors, welcher für mittlere Kollektor-Emitter- Spannungen geeignet ist;
Fig. 2 eine schematische Querschnittsansicht eines Ausführungsbeispiels eines LDVB-Transistors für größere Ausgangsspannungen;
Fig. 3 eine gemessene Ausgangskennlinie eines erfindungsgemäßen LDVB-Transistors; und
Fig. 4 eine gemessene Ausgangskennlinie eines Hetero-Bipolartransistors nach dem Stand der Technik, also ohne Kollektor-Driftgebiet.

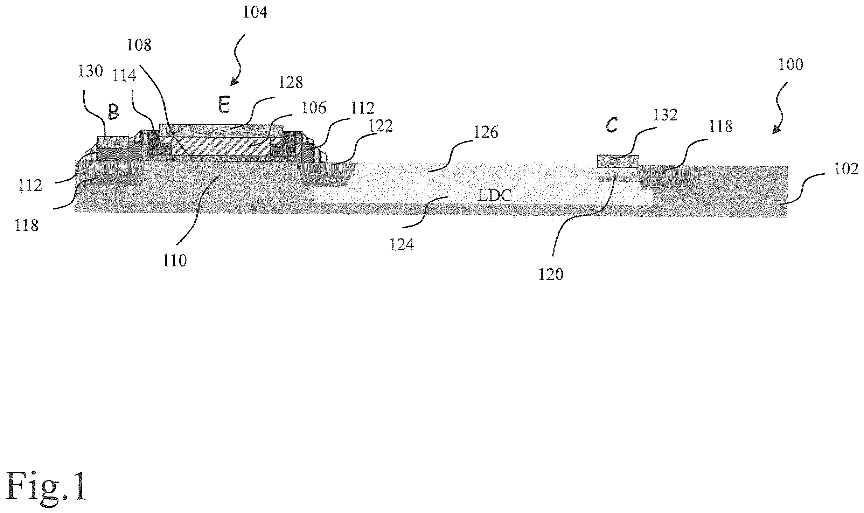

Fig. 1 zeigt eine schematische Querschnittsansicht eines Ausführungsbeispiels eines npn-LDVB-Transistors 100, welcher für mittlere Kollektor-Emitter-Spannungen, typischerweise |BV_{CE0}| < 40 V geeignet ist.

Der LDVB-Transistor 100 ist npn-Transistor, der in und auf einem p-dotierten Siliziumsubstrat 102 gebildet ist. Der Transistor umfasst in seinem inneren Transistorgebiet 104 eine vertikale Schichtfolge einer T-förmigen Emitterschicht 106, einer Basisschicht 108 und einer im Substrat angeordneten Kollektorschicht 110. Die Emitterschicht 106 und die seitlich zu einem Basisanschlussgebiet 112 hin hochgezogene Basisschicht 108 sind durch eine Isolationsschicht 114 voneinander getrennt. Weitere fachübliche Isolationsschichten sind vorhanden, werden hier jedoch nicht näher erläutert.

Der LDVB-Transistor ist außen von einer Isolationsschicht 118 umgeben. Zwischen dem inneren Transistorgebiet und dem Kollektoranschlussgebiet 120 ist ein weiteres Isolationsgebiet 122 angeordnet, das hier in der lateralen Kombination aus einem Shallow-Trench- und CVD-Oxid gefertigt ist. Unterhalb des Isolationsgebiets 122 grenzt an die Kollektorschicht 110 ein Kollektor-Driftgebiet 124 an. Das Kollektor-Driftgebiet schließt lateral an das innere Kollektorgebiet 110 an und erstreckt sich als vergrabene niedrig dotierte Schicht bis zum Kollektoranschlussgebiet 120. Es bildet die einzige elektrische Verbindung des inneren Kollektorgebiets 110 mit dem Kollektoranschlussgebiet 120. Zwischen dem Isolationsgebiet 122 und dem Kollektoranschlussgebiet 120 erstreckt sich über dem Kollektor-Driftgebiet 124 ein RESURF-Gebiet 126. Anschlüsse für Emitter, Basis und Kollektor sind unter den Bezugszeichen 128, 130 und 132 dargestellt.

Im aktiven normalen Betrieb, d.h. bei VBE > 0V (VBE bezeichnet die Basis-Emitter-Spannung) und VCB > 0V (VBC bezeichnet die Basis-Kollektor-Spannung), erreichen die vom Emitter in die Basis injizierten Elektronen unter nur geringen Rekombinationsverlusten das Kollektorgebiet und werden dort unter Wirkung des elektrischen Feldes in dem an freien Trägern verarmten lateralen Kollektor-Driftgebiet zum Kollektoranschlussgebiet transportiert. Die Laufzeit in diesem Driftgebiet wird durch die in weiten Grenzen skalierbare Driftgebiet-Länge in lateraler Richtung sowie durch die Driftgeschwindigkeit in diesem Driftgebiet bestimmt.

Wie im Beispiel der Fig. 1 gezeigt, kann mittels einer oberflächennahen p-RESURF (reduced surface field)-Dotierung die n-Dotierungsdosis im lateralen Driftgebiet erhöht werden, ohne dass der kritische Maximalwert der lateral zu verarmenden Ladungsträgerdosis von ca. 2.5x10¹² cm⁻² überschritten wird. Dies führt zu einer vorteilhaften Reduzierung des Kollektorwiderstandes und damit zu einer Verbesserung der Hochfrequenzeigenschaften des Transistors.

Im Folgenden wird beispielhaft die Herstellung eines erfindungsgemäßen npn-Hetero-Bipolatransistors mit lateralem Kollektor-Driftraum gemäß Figur 1 umrissen, wobei nur auf diejenigen Prozessschritte eingegangen wird, welche zur Herstellung des lateralen Driftraumes notwendig sind. Auf die jeweils spezifischen Herstellungsschritte für vertikale npn-Hetero-Bipolartransitoren im Rahmen von Bi-CMOS Technologien wird nicht weiter eingegangen. Diese sind beispielsweise aus der Veröffentlichung D. Knoll, K.-E. Ehwald, B. Heinemann, A. Fox, K. Blum, H. Rücker, F. Fürnhammer, B. Senapati, R. Barth, U. Haak, W. Höppner, J. Drews, R. Kurps, S. Marschmeyer, H.H. Richter, T. Grabolla, B. Kuck, O. Fursenko, P. Schley, B. Tillack, Y. Yamamoto, K. Köpke, H.-E. Wulf, D. Wolansky, W. Winkler, "A Flexible, Low Cost, High Performance SiGe:C BiCMOS Process with a One-Mask HBT Module ". Proc. IEDM, 775 (2002) bekannt.

Mittels Ionenimplantation kann der erfindungsgemäße LDVB-Transistor in einen BiCMOS Prozess auf einfache Weise integriert werden. Im Rahmen der zur Herstellung des vertikalen npn-Hetero-Bipolartransistors gemäß Fig. 1 notwendigen Prozessschritte werden das vertikale (innere) Kollektorgebiet und das laterale Kollektor-Driftgebiet LDC vorzugsweise mittels separater Maskenschritte implantiert und anschließend thermisch ausgeheilt. Dabei wird die Subkollektordotierung im vertikalen Kollektorgebiet des npn-Hetero-Bipolartransistors zur Vermeidung von Feldstärkespitzen gegenüber herkömmlich verwendeten hohen Dotierstoffkonzentrationen reduziert, um einen vorzeitigen Kollektor-Basis-Durchbruch zu vermeiden.

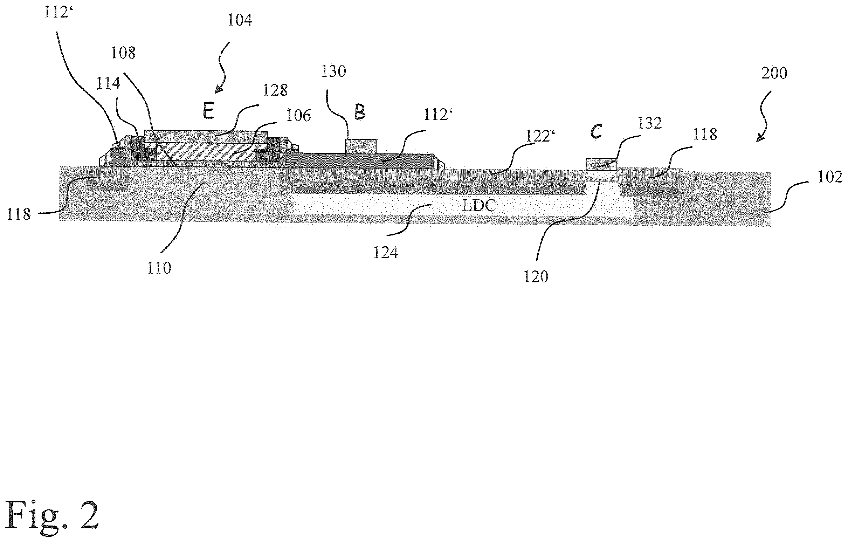

Fig. 2 zeigt eine schematische Querschnittsansicht eines Ausführungsbeispiels eines LDVB-Transistors 200 für größere Ausgangsspannungen, typischerweise |VCE0| > 40 V.

Die Darstellung der Fig. 2 verwendet für das Strukturelement, welches bereits aus dem Ausführungsbeispiel der Figur 1 bekannt sind, identische Bezugszeichen. Die nachfolgende Beschreibung beschränkt sich auf die Erläuterung der Unterschiede gegenüber dem Ausführungsbeispiel der Fig. 1.

Hier ist das über dem Kollektor-Driftgebiet 124 liegende Isolationsgebiet 122' vollständig in Shallow-Trench-Technik ausgeführt und erstreckt sich in lateraler Richtung vom inneren Kollektorgebiet 110 bis zum Kollektoranschlussgebiet 120. Die Transistorstruktur der Fig. 2 unterscheidet sich außerdem von der Fig. 1 durch ein auf dem Isolationsgebiet liegendes lateral verlängertes Basisanschlussgebiet 112'. Dieses Basis-Anschlussgebiet 112 wirkt zugleich als Feldplatte. Es ist darüberhinaus möglich, statt der Integration beider Funktionen Basisanschlussgebiet/Feldplatte getrennte Anordnungen von separat angeschlossenen Feldplatten auf der Isolationsgebiet 122' vorzusehen.

Die LDVB-Transistorkonstruktion 200 dieses Ausführungsbeispiels ist also zur Erzielung einer erhöhten Spannungsfestigkeit mit dem als Feldplatte ausgebildeten Basisanschlussgebiet 122' aus Poly-Silizium ausgestattet, das sich über dem nach oben dielektrisch isolierten lateralen Driftraum befindet. Die auf dem Isolationsgebiet liegenden zusätzlichen Feldplatten über dem lateralen Kollektor-Driftraum wird im Rahmen von in CMOS-Prozessen bereits vorhandenen Herstellungsschritten gebildet, insbesondere in Verbindung mit der Herstellung der Isolationsschicht, also STI (shallow trench isolation), LOCOS (local oxidation of silicon) oder CVD(chemical vapour deposition), und/oder einer polykristallinen oder amorphen Siliziumschicht zur Herstellung von MOS-Gates von MOS-Transistoren.

Zur Vermeidung des Durchbruchs infolge Stoßionisation und Lawinenvervielfachung darf die Feldstärke weder im Kollektorgebiet unterhalb der Basis, noch am Rande des Kollektor-Anschlussgebietes einen gewissen Grenzwert überschreiten. Deshalb ist das Potenzial auf den Feldplatten, welches eine Absenkung des Potenzials im Driftraum bewirkt, auf geeignete Werte zwischen 0V und VCC zu legen.

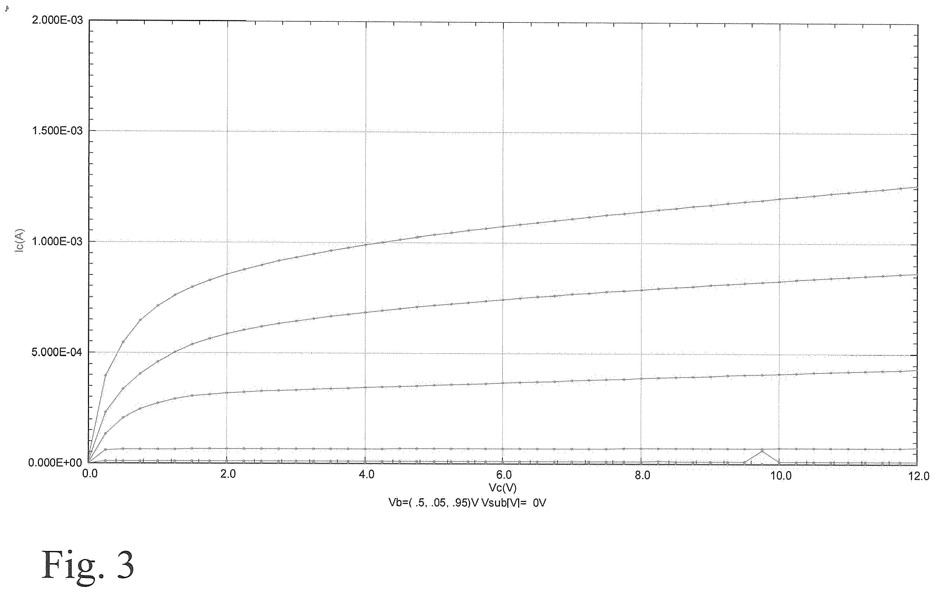

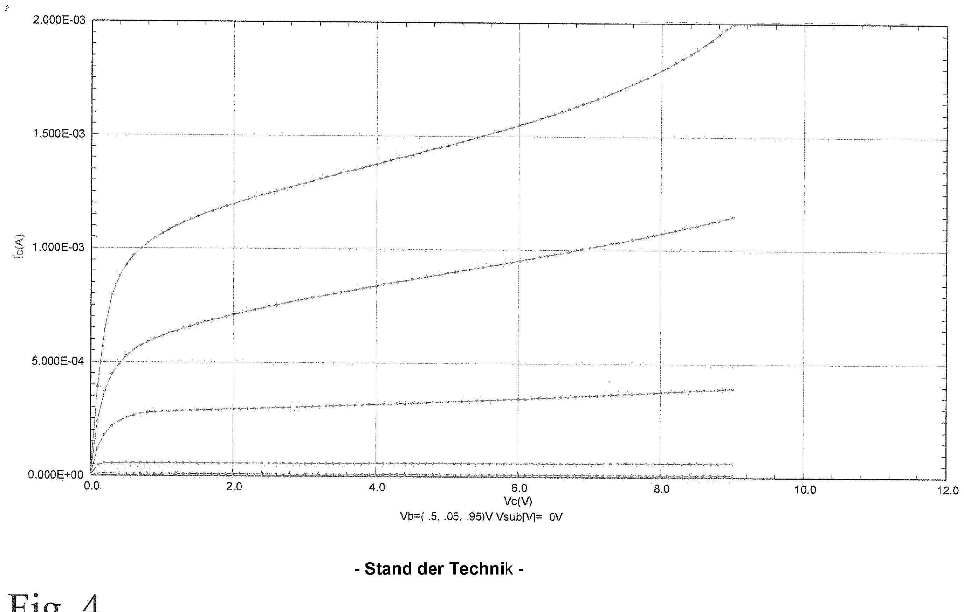

Die in Figur 3 und Figur 4 dargestellten Beispiele gemessener Ausgangskennlinien (Kollektorstrom I_{C} in Ampere als Funktion der Kollektor-Emitterspannung V_{C} in Volt) einander ansonsten entsprechender Heterobipolartransistoren mit und ohne zusätzliches laterales Kollektor-Driftgebiet verifizieren die Anwendung des Konstruktionsprinzips eines zusätzlichen lateralen Driftraumes und des Herstellungsverfahrens zur Erhöhung der Spannungsfestigkeit vertikaler Bipolartransistoren. Dargestellt sind Kennlinien für Basisspannungen von 0,75 bis 0,95 V in 0,05 V Schritten. Die Ausgangskennlinie der Fig. 3 lässt sich bei geeigneter Dimensionierung des lateralen Kollektor-Driftgebietes zu Kollektor-Emitter-Spannungen oberhalb von 40 V fortsetzen, ohne in den in Fig. 4 erkennbaren stark nicht-linearen Anstieg des Kollektorstroms überzugehen.

## Patentansprüche

1. Vertikaler npn-Bipolartransistor (100) mit einem lateralen Driftgebiet, LDVB-Transistor, mit einer vertikalen Schichtfolge von Emitter (106), Basis (108) und Kollektor, bei dem der Kollektor ein dotiertes inneres Kollektorgebiet (110) eines ersten Leitfähigkeitstyps, nämlich eines n-Leitfähigkeitstyps, und ein im Vergleich mit dem inneren Kollektorgebiet höher dotiertes Kollektoranschlussgebiet (120) des ersten Leitfähigkeitstyps aufweist, und bei dem an das innere Kollektorgebiet in einer lateralen Richtung, die quer zu einer vertikalen Stapelrichtung der Schichtfolge weist, ein im Vergleich mit dem inneren Kollektorgebiet schwächer dotiertes Kollektor-Driftgebiet (124) des ersten Leitfähigkeitstyps anschließt, über welches das innere Kollektorgebiet mit dem Kollektoranschlussgebiet verbunden ist und welches die einzige elektrische Verbindung zwischen dem inneren Kollektorgebiet (110) und dem Kollektoranschlussgebiet (120) darstellt, und mit einem p-dotierten Silizium-Substrat (102), welches unterhalb des Kollektor-Driftgebietes (124) sowohl über die gesamte Erstreckung des Kollektor-Driftgebietes in der lateralen Richtung als auch über die gesamte Erstreckung des Substrats (102) in seiner zur Stapelrichtung entgegengesetzten Tiefenrichtung durchweg kein zur Reduzierung des Kollektorwiderstandes geeignetes Hochdotierungsgebiet vom ersten Leitfähigkeitstyp aufweist, bei dem die Dotierstoffkonzentration des Kollektor-Driftgebiets (124) derart bemessen ist, dass eine maximale flächenbezogene Dichte von freien Ladungsträgern von 2.5x10¹² cm⁻² nicht überschritten wird.

2. Vertikaler npn-Bipolartransistor nach Anspruch 1, bei dem das innere Kollektorgebiet sich von einer Grenzfläche mit einer Basisschicht (108) ausgehend in der vertikalen Richtung in das Substrat hinein erstreckt, und bei dem das Kollektor-Driftgebiet (124) im Substrat (102) lateral vergraben angeordnet ist.

3. Vertikaler npn-Bipolartransistor nach Anspruch 1 oder 2, bei dem in der vertikalen Richtung über dem Kollektor-Driftgebiet (124) und in der lateralen Richtung zwischen dem inneren Kollektorgebiet (110) und dem Kollektor-Anschlussgebiet (120) ein Isolationsgebiet (122, 122') angeordnet ist.

4. Vertikaler npn-Bipolartransistor nach Anspruch 3, bei dem, in der vertikalen Richtung betrachtet, über dem Kollektor-Driftgebiet (124) und, in der lateralen Richtung betrachtet, zwischen dem Isolationsgebiet und dem Kollektor-Anschlussgebiet ein RESURF-Gebiet (126) eines dem ersten Leitfähigkeitstyp entgegengesetzten zweiten Leitfähigkeitstyps angeordnet ist.

5. Vertikaler npn-Bipolartransistor nach einem der vorstehenden Ansprüche, der lateral durch ein in Shallow-Trench- oder LOCOS-Technik hergestelltes Bauelemente-Isolationsgebiet umgeben ist.

6. Vertikaler npn-Bipolartransistor nach einem der Ansprüche 3 oder 5, bei dem sich das Isolationsgebiet (122') in der lateralen Richtung über die gesamte laterale Ausdehnung des Kollektor-Driftgebiets (124) bis zum Kollektor-Anschlussgebiet (120) erstreckt.

7. Vertikaler npn-Bipolartransistor nach Anspruch 6, bei dem das Isolationsgebiet (122') von Feldplatten zur Steuerung der Potentialverteilung im Kollektor-Driftgebiet (124) bedeckt ist.

8. Vertikaler npn-Bipolartransistor nach Anspruch 6 oder 7, bei dem auf dem Isolationsgebiet (122') ein mit einem inneren Basisgebiet (108) verbundenes Basisanschlussgebiet (112) des zweiten Leitfähigkeitstyps angeordnet ist, welches sich als Feldplatte in lateraler Richtung über einen Teil des Isolationsgebiets abdeckt.

9. Vertikaler npn-Bipolartransistor nach Anspruch 8, bei dem das Basisanschlussgebiet (112) sich etwa über die Hälfte der lateralen Ausdehnung des Isolationsgebiets (122') erstreckt.

10. Vertikaler npn-Bipolartransistor gemäß einem der vorstehenden Ansprüche, bei dem eine Dotierstoffkonzentration des Kollektor-Driftgebiets (124) derart bemessen ist, dass das Kollektor-Driftgebiet ab einem vorbestimmten, insbesondere geringen Schwellwert einer Kollektor-Emitter-Spannung vollständig an freien Ladungsträgern verarmt ist.

11. Verfahren zur Herstellung eines vertikalen npn-Bipolartransistors mit einem lateralen Driftgebiet nach einem der vorstehenden Ansprüche, umfassend,
- Herstellung des Bipolar-Transistors auf einem p-dotierten Silizium-Substrat (102) mittels Halbleiterfertigungstechnologien, insbesondere im Rahmen eines Bi-CMOS-Prozesses, umfassend eine Ausbildung einer vertikalen Schichtfolge von Emitter (106), Basis (108) und Kollektor,
- wobei der Kollektor mit einem dotierten inneren Kollektorgebiet (110) eines ersten Leitfähigkeitstyps und einem im Vergleich mit dem inneren Kollektorgebiet höher dotierten Kollektoranschlussgebiet (120) des ersten Leitfähigkeitstyps hergestellt wird, und
- wobei an das innere Kollektorgebiet in einer lateralen Richtung, die quer zu einer vertikalen Stapelrichtung der Schichtfolge weist, angrenzend ein dotiertes Kollektor-Driftgebiet (124) des ersten Leitfähigkeitstyps hergestellt wird, über welches das innere Kollektorgebiet mit dem Kollektoranschlussgebiet verbunden ist,
- bei dem die Dotierstoffkonzentration des Kollektor-Driftgebiets (124) derart bemessen ist, dass eine maximale flächenbezogene Dichte von freien Ladungsträgern von 2.5x10¹² cm⁻² nicht überschritten wird.

12. Verfahren nach Anspruch 11, bei dem das Kollektor-Driftgebiet (124) im Vergleich mit dem inneren Kollektorgebiet schwächer dotiert wird.

13. Verfahren nach Anspruch einem der Ansprüche 11 oder 12, bei dem das Kollektor-Driftgebiet (124) mittels Ionenimplantation in einem von einer Dotierung des inneren Kollektorgebiets getrennten Maskenschritt dotiert wird.

## Claims

1. Vertical npn bipolar transistor (100) comprising a lateral drift region, LDVB transistor, with a vertical layer sequence of emitter (106), base (108) and collector, wherein the collector has a doped inner collector region (110) of a first conductivity type, namely an n-conductivity type, and a collector connection region (120) doped more heavily than the inner collector region, and wherein to the inner collector region in lateral direction, which is perpendicular to a vertical stacking direction of the layer sequence, a collector drift region (124) of the first conductivity type doped more lightly than the inner collector region is attached, by means of which the inner collector region is connected to the collector connection region and which represents the single electrical connection between the inner collector region (110) and the collector connection region (120), and comprising a p-doped silicon substrate (102), which below the collector drift region (124) over the whole extension of the collector drift region in lateral direction and also over the whole extension of the substrate (102) in its depth direction opposite the stacking direction has throughout no high dopant region of the first conductivity type which is suitable for reducing the collector resistance, wherein the dopant concentration of the collector drift region (124) is measured such that a maximum areal density of free charge carriers of 2.5x10¹²cm⁻² is not exceeded.

2. Vertical npn bipolar transistor according to claim 1, wherein the inner collector region extends from a boundary with a base layer (108) in vertical direction into the substrate, and wherein the collector drift region (124) is arranged buried laterally in the substrate (102).

3. Vertical npn bipolar transistor according to claim 1 or 2, wherein in vertical direction above the collector drift region (124) and in lateral direction between the inner collector region (110) and the collector connection region (120) an insulation region (122, 122') is arranged.

4. Vertical npn bipolar transistor according to claim 3, wherein, as viewed in vertical direction, above the collector drift region (124) and, as viewed in lateral direction, between the insulation region and the collector connection region a RESURF region (126) of a second conductivity type opposite the first conductivity type is arranged.

5. Vertical npn bipolar transistor according to any of the preceding claims, which is surrounded laterally by a component insulation region produced by a shallow trench or LOCOS technique.

6. Vertical npn bipolar transistor according to any of claims 3 or 5, wherein the insulation region (122') extends in lateral direction over the whole lateral extension of the collector drift region (124) up to the collector connection region (120).

7. Vertical npn bipolar transistor according to claim 6, wherein the insulation region (122') is covered by field plates for controlling the potential distribution in the collector drift region (124).

8. Vertical npn bipolar transistor according to claim 6 or 7, wherein on the insulation region (122') a base connection region (112) of the second conductivity type connected to an inner base region (108) is arranged which is covered as a field plate in lateral direction over a portion of the insulation region

9. Vertical npn bipolar transistor according to claim 8, wherein the base connection region (112) extends approximately over half the lateral extension of the insulation region (122').

10. Vertical npn bipolar transistor according to any of the preceding claims, wherein a dopant concentration of the collector drift region (124) is measured such that the collector drift region is fully depleted on free charge carriers from a predefined, in particular low threshold of a collector emitter voltage.

11. Method for producing a vertical npn bipolar transistor with a lateral drift region according to any of the preceding claims, comprising,
- producing the bipolar transistor on a p-doped silicon substrate (102) by means of technologies for the production of semiconductors, in particular as part of a Bi-CMOS process, comprising forming a vertical layer sequence of emitter (106), base (108) and collector,
- wherein the collector is produced with a doped inner collector region (110) of a first conductivity type and a collector connection region (120) of the first conductivity type which is more heavily doped than the inner collector region, and
- wherein adjoining the inner collector region in lateral direction, which is perpendicular to a vertical stacking direction of the layer sequence, a doped collector drift region (124) of the first conductivity type is produced, by means of which the inner collector region is connected to the collector connection region,
- wherein the dopant concentration of the collector drift region (124) is measured such that a maximum areal density of free charge carriers of 2.5x10¹²cm⁻² is not exceeded.

12. Method according to claim 11, wherein the collector drift region (124) is less heavily doped than the inner collector region.

13. Method according to any of claims 11 or 12, wherein the collector drift region (124) is doped by means of ion implantation in a mask step separate from doping the inner collector region.

## Revendications

1. Transistor bipolaire npn vertical (100) avec une zone de migration, un transistor LDVB, avec une série de couches verticale d'émetteur (106), de base (108) et de collecteur, dans lequel le collecteur comprend une zone de collecteur interne dopée (110) d'un premier type de conductivité, à savoir d'un type de conductivité n, et une zone de raccordement de collecteur (120), dopée de manière plus élevée par rapport à la zone de collecteur interne, du premier type de conductivité et dans lequel, à la zone de collecteur interne, dans une direction latérale, qui est orientée transversalement par rapport à une direction d'empilement verticale de la série de couches, se raccorde une zone de migration de collecteur (124), dopée de manière plus faible par rapport à la zone de collecteur interne, du premier type de conductivité, par l'intermédiaire de laquelle la zone de collecteur interne est reliée avec la zone de raccordement de collecteur et qui représente la seule liaison électrique entre la zone de collecteur interne (110) et la zone de raccordement de collecteur (120), et avec un substrat de silicium dopé p (102), qui ne comprend, en dessous de la zone de migration de collecteur (124) ainsi que sur toute l'extension de la zone de migration de collecteur, dans la direction latérale ainsi que sur toute l'extension du substrat (102), dans sa direction de profondeur opposée à la direction d'empilement, aucune zone de dopage élevé adapté à la réduction de la résistance du collecteur, du premier type de conductivité, dans lequel la concentration de matériau de dopage de la zone de migration du collecteur (124) est dimensionnée de façon à ce qu'une densité maximale en fonction de la surface de porteurs de charges libres de 2,5x10¹² cm⁻² ne soit pas dépassée.

2. Transistor bipolaire npn vertical selon la revendication 1, dans lequel la zone de collecteur interne s'étend à partir d'une surface limite avec une couche de base (108) dans la direction verticale dans le substrat et dans lequel la zone de migration du collecteur (124) est disposée dans le substrat (102) de manière enfouie latéralement.

3. Transistor bipolaire npn vertical selon la revendication 1 ou 2, dans lequel, dans la direction verticale, au-dessus de la zone de migration de collecteur (124) et dans la direction latérale entre la zone de collecteur interne (110) et la zone de raccordement de collecteur (120), se trouve une zone d'isolation (122, 122').

4. Transistor bipolaire npn vertical selon la revendication 3, dans lequel, vue dans la direction latérale, au-dessus de la zone de migration de collecteur (124), vu dans la direction latérale, entre la zone d'isolation et la zone de raccordement de collecteur, se trouve une zone RESURF (126) d'un deuxième type de conductivité opposé au premier type de conductivité.

5. Transistor bipolaire npn vertical selon l'une des revendications précédentes, qui est entouré latéralement par une zone d'isolation de composants réalisée à l'aide d'une technique « shallow-trench » ou LOCOS.

6. Transistor bipolaire npn vertical selon l'une des revendications 3 ou 5, dans lequel la zone d'isolation (122') s'étend dans la direction latérale sur toute l'extension latérale de la zone de migration du collecteur (124) jusqu'à la zone de raccordement du collecteur (120).

7. Transistor bipolaire npn vertical selon la revendication 6, dans lequel la zone d'isolation (122') est recouverte de plaques de champ pour le contrôle de la répartition de potentiel dans la zone de migration du collecteur (124).

8. Transistor bipolaire npn vertical selon la revendication 6 ou 7, dans lequel, sur la zone d'isolation (122'), se trouve une zone de raccordement de base (112) reliée avec une zone de base interne (108), du deuxième type de conductivité, qui recouvre, sous la forme d'une plaque de champ dans la direction latérale, une partie de la zone d'isolation.

9. Transistor bipolaire npn vertical selon la revendication 8, dans lequel la zone de raccordement de base (112) s'étend environ sur la moitié de l'extension latérale de la zone d'isolation (122').

10. Transistor bipolaire npn vertical selon l'une des revendications précédentes, dans lequel une concentration en matériau de dopage de la zone de migration de collecteur (124) est dimensionnée de façon à ce que la zone de migration du collecteur soit entièrement appauvrie des porteurs de charges libres à partir d'une valeur seuil prédéterminée, plus particulièrement faible, d'une tension collecteur-émetteur,

11. Procédé de fabrication d'un transistor bipolaire npn vertical avec une zone de migration latérale selon l'une des revendications précédentes, comprenant
- la fabrication du transistor bipolaire sur un substrat de silicium dopé p (102) au moyen de technologies de fabrication de semi-conducteurs, plus particulièrement dans le cadre d'un processus Bi-CMOS, comprenant la formation d'une série de couches verticale d'émetteur (106), de base (108) et de collecteur,
- dans lequel le collecteur est fabriqué avec une zone de collecteur inter dopée (110) d'un premier type de conductivité et une zone de raccordement de collecteur (120) dopée de manière plus élevée par rapport à la zone de collecteur interne, du premier type de conductivité et
- dans lequel, à proximité de la zone de collecteur interne est orientée dans une direction latérale qui est transversale par rapport à une direction d'empilement verticale de la série de couches, est fabriquée une zone de migration de collecteur dopée (124) du premier type de conductivité, par l'intermédiaire de laquelle la zone de collecteur interne est reliée avec la zone de raccordement de collecteur,
- dans lequel la concentration en matériau de dopage de la zone de migration de collecteur (124) est dimensionnée de façon à ce qu'une densité maximale par rapport à la surface de porteurs de charges libres de 2,5x10¹² cm⁻² ne soit pas dépassée.

12. Procédé selon la revendication 11, dans lequel la zone de migration de collecteur (124) est dopée de manière plus faible par rapport à la zone de collecteur interne.

13. Procédé selon l'une des revendications 11 ou 12, dans lequel la zone de migration de collecteur (124) est dopée au moyen d'une implantation d'ions dans une étape de masquage distincte d'un dopage de la zone de collecteur interne.
